# EUROPÄISCHE PATENTSCHRIFT

(11) **EP 3 104 186 B1**
(45) Veröffentlichungstag und Bekanntmachung des Hinweises auf die Patenterteilung: **16.09.2020**
(21) Anmeldenummer: 15170985.4
(22) Anmeldetag: 08.06.2015
(51) Int. Cl.: G01R 33/09, H01L 41/00, H01L 41/047, G01R 33/00, G01R 33/06, G01R 33/18

(54) **MAGNETOELEKTRISCHE MAGNETFELDMESSUNG MIT FREQUENZUMSETZUNG**
MAGNETO-ELECTRIC MAGNETIC FIELD MEASUREMENT WITH FREQUENCY CONVERSION
MESURE MAGNÉTOÉLECTRIQUE DU CHAMP MAGNÉTIQUE À L'AIDE DE CONVERSION DE FRÉQUENCE

(43) Veröffentlichungstag der Anmeldung: 14.12.2016
(73) Patentinhaber: Christian-Albrechts-Universität zu Kiel, 24118 Kiel (DE)
(72) Erfinder: Hayes, Patrick, 24232 Schönkirchen (DE); Piorra, André, 24118 Kiel (DE); Knöchel, Reinhard, 25336 Elmshorn (DE); Quandt, Eckhard, 24226 Heikendorf (DE)
(74) Vertreter: Hansen, Jochen

(56) Entgegenhaltungen:
- EP-B1- 2 538 235
- EP-B1- 2 717 343
- DE-A1-102011 008 866
- US-B1- 8 222 898

## Beschreibung

Die Erfindung betrifft ein Verfahren und Vorrichtungen zur Messung zeitlich veränderlicher Magnetfelder mittels Sensoren aus magnetoelektrischen Kompositmaterialien, auch kurz ME-Sensoren genannt.

Magnetoelektrische Komposite sind polymorphe Materialien, die aus wenigstens zwei Materialphasen in stoffschlüssiger Verbindung, z.B. miteinander verlötet oder verklebt, gebildet sind: eine magnetostriktive Phase und eine piezoelektrische Phase.

Die magnetostriktive Phase ist typisch metallisch, z.B. kommen ferromagnetische Übergangsmetalle Eisen, Nickel, Cobalt (Fe, Ni, Co) und deren Legierungen, Verbindungen der Seltenen Erden Terbium, Dysprosium, Samarium (Tb, Dy, Sm) mit den ferromagnetischen Übergangsmetallen (z.B. TbFe₂, SmFe₂), ferromagnetische Gläser vorwiegend enthaltend die Elemente Eisen, Kobalt, Bor (B) oder Silizium (Si) in variierenden Anteilen oder Gallium (Ga) enthaltende Materialien FeGa und FeGaB in Frage. Weiterhin kann die magnetostriktive Phase auch aus einem nichtleitenden Material gebildet sein, etwa aus CoFeO₃ oder NiFeO₃. Unter der Einwirkung eines magnetischen Feldes erfährt sie eine Längen-, Gestalts- oder Volumenänderung.

Die piezoelektrische Phase, z.B. aus Blei-Zirkonat-Titanat (PZT), Polyvinylidenfluorid (PVDF), Aluminiumnitrid (AIN), erfährt infolge der stoffschlüssigen Verbindung mit der magnetostriktiven Phase im ME-Komposit durch ein Magnetfeld ebenfalls eine Längenänderung und erzeugt dabei eine messbare Änderung der elektrischen Polarisation, die als elektrische Spannungs- oder Ladungsänderung mittels einer unmittelbar auf der piezoelektrischen Phase befindlichen Messelektrodenanordnung detektiert werden kann.

Auf der mechanischen Kraftkopplung der beiden Phasen basiert das ME-Sensorprinzip zur Magnetfeldmessung.

Für die Formgebung der beiden Materialphasen gibt es keine zwingenden Vorgaben. Beispielsweise können Bulkmaterialien beliebiger Gestalt zusammengefügt, insbesondere miteinander verklebt, werden und bilden hiernach ein magnetoelektrisches Kompositelement entsprechend einer Formvorgabe.

Es hat sich als zweckdienlich erwiesen und ist heute gängig, beide Phasen als Schichten aufeinander abzuscheiden und entlang der Schichtebenen in rechteckige Streifenform zuzuschneiden. Die Streifen sind vornehmlich sensitiv für Magnetfeldvektorkomponenten, die parallel zur langen Streifenachse gerichtet sind.

Die Streifen vollführen in Anwesenheit eines solchen Magnetfeldes je nach Streifenaufbau eine Biege- oder Streckbewegung und können durch ein zeitlich periodisches Magnetfeld zu mechanischen Schwingungen angeregt werden, wenn sie entsprechend schwingfähig gelagert, z.B. einseitig eingespannt, sind. ME-Sensoren sind grundsätzlich als mechanische Oszillatoren ausgebildet und besitzen eine mechanische Eigenfrequenz, die leicht bestimmt werden kann.

Der Abgriff der Messspannung über die piezoelektrische Phase erfolgt mittels der erwähnten Messelektrodenanordnung gewöhnlich über die Schichtdicke, wobei eine metallische magnetostriktive Phase als Gegenelektrode benutzt werden kann. Aus der Patentschrift EP 2 717 343 B1 ist aber auch bekannt, die Messelektrodenanordnung z.B. als Interdigitalelektroden auszulegen und entlang der Schicht zu messen, was insbesondere bei der Fertigung der ME-Sensoren in Dünnschichttechnik Vorteile hat. Dieselbe Patentschrift lehrt auch, dass es keineswegs erforderlich ist, die beiden Materialphasen unmittelbar aufeinander abzuscheiden, um ein sensorfähiges ME-Komposit zu erhalten. Die mechanische Kopplung der Phasen kann auch durch eine hinreichend starre, im Übrigen dielektrische und vergleichsweise sehr dicke Trennschicht hindurch erfolgen.

ME-Sensoren sind ohne weitere Ansteuerungen nur für magnetische Wechselfelder sensitiv und werden gewöhnlich auch außerhalb ihrer mechanischen Resonanz betrieben. Da man an einer möglichst großen Messdynamik, einem möglichst großen Signal-Rausch-Verhältnis und an der Linearität der Spannungsantwort bezüglich des zu messenden magnetischen Wechselfeldes interessiert ist, wählt man für den ME-Sensor einen Arbeitspunkt im Bereich des größten Anstiegs der Magnetostriktionskennlinie. Die erste Ableitung der Magnetostriktionskennlinie wird als piezomagnetischer Koeffizient bezeichnet. Die Magnetostriktionskennlinie beschreibt die Längenausdehnung der magnetostriktiven Phase unter der Wirkung eines Magnetfeldes. Ihr Verlauf ist stets achsensymmetrisch, da beide Feldrichtungen denselben Effekt auf das Material haben. Die Längenausdehnung weist für kleine Feldstärken zunächst einen parabolischen Anstieg auf, ist aber für große Feldstärken nach oben beschränkt - bei Erreichen der Sättigungsmagnetisierung. Sie besitzt folglich einen Wendepunkt, in dem der lineare Anstieg dominiert und wo zugleich die größte Steigung vorliegt. Um den ME-Sensor in diesem günstigen Arbeitspunkt zu betreiben, wird vorzugsweise ein konstantes Bias-Magnetfeld durch das geeignete Anordnen von Stromleitern oder Permanentmagneten angelegt.

Ein solches statisches Bias-Magnetfeld ist jedoch in der Anwendungspraxis nicht unproblematisch. Gerade bei mehreren ME-Sensoren in enger Nachbarschaft zueinander können wechselseitige Einflüsse der magnetischen Bias-Felder auftreten, insbesondere dann, wenn die Felder nach dem Biot-Savart-Gesetz erzeugt werden und die Ströme über Zuleitungen zu führen sind. Permanentmagnetische Bias-Felder sind energetisch günstiger, erfordern aber das Anordnen einer ausreichenden Menge magnetischen Materials, um geeignete Feldstärken zu erzielen.

Die Detektionsgrenze eines ME-Sensors besitzt eine typische Frequenzabhängigkeit, die durch das Eigenrauschen wie z.B. das thermische Rauschen oder das frequenzabhängige 1/f-Stromrauschen des elektronischen Verstärkers und den frequenzabhängigen magnetoelektrischen Koeffizienten bestimmt ist. Letzterer beschreibt das Verhältnis der im ME-Sensor hervorgerufenen elektrischen Feldstärkeamplitude zur anregenden magnetischen Feldstärkeamplitude. Der magnetoelektrische Koeffizient zeigt eine deutliche Erhöhung im Bereich der mechanischen Eigenfrequenz eines ME-Sensors, was an der Resonanzverstärkung der Schwingungsamplitude liegt.

Insbesondere für niedrige Frequenzen des magnetischen Wechselfeldes, z.B. 1-10 Hz, wie sie für biomagnetische Messungen relevant sind, ergibt sich aus dem Vorgesagten eine deutliche Verschlechterung der Detektionsgrenze. Durch das 1/f-Rauschen verliert man ca. 3 Größenordnungen an Empfindlichkeit und durch die fehlende Resonanzverstärkung in diesem Niederfrequenzbereich noch weitere 2-3 Größenordnungen. Dies führt dazu, dass die in der mechanischen Resonanz bei etwa 1 kHz erreichten Detektionsgrenzen von besser als 1 pT/Hz^{1/2} sich bei 1Hz auf mindestens 100 nT/Hz^{1/2} verschlechtern.

Die Patentschrift EP 2 635 913 B1 adressiert das Problem der Messung langsam veränderlicher, schwacher Magnetfelder mit ME-Sensoren. Dort wird eine Frequenzumsetzung in die mechanische Resonanz des ME-Sensors vorgeschlagen, die durch Überlagern des zu messenden Magnetfeldes, i. F. Messmagnetfeld, mit einem kontrollierten Modulationsmagnetfeld auf dem Sensor erreicht wird. Die Druckschrift führt dazu aus, dass der Verlauf der Magnetostriktionskennlinie ursächlich dafür ist, dass der Sensor Magnetfeldanteile mit Mischfrequenzen detektiert, insbesondere solche, die Summe und Differenz aus Messmagnetfeld-Frequenz, i. F. kurz Messfeldfrequenz, und Modulationsmagnetfeld-Frequenz, i. F. kurz Modulationsfrequenz, aufweisen. Dadurch wird es möglich, mittels gezielter Auswahl der Modulationsfrequenz passend zur vorbekannten mechanischen Eigenfrequenz des ME-Sensors auch ein Messmagnetfeld mit sehr niedriger Messfeldfrequenz in der Resonanz des ME-Sensors zu detektieren. Das Signal bei der Messfeldfrequenz wird durch einen physikalischen Mischvorgang zu seinem Nachweis auf die Resonanzfrequenz umgesetzt. Weiterhin führt die EP 2 635 913 B1 aus, dass für den Fall, dass ein Spektrum niedriger Messfrequenzen untersucht werden soll, auch ein Variieren der Modulationsfrequenz über ein entsprechend komplementäres Frequenzband durchgeführt werden kann, um eine Mehrzahl von Messfrequenzen sequenziell umzusetzen und zu detektieren.

Die Frequenzumsetzung hat neben der Vermeidung des 1/f-Rauschen und der Resonanzverstärkung auch langsam oszillierender Magnetfeldanteile überdies den Vorteil, dass der ME-Sensor nicht unmittelbar mit einem Bias-Gleichfeld ausgestattet werden muss. Insbesondere sind keine Permanentmagneten erforderlich. Allerdings wird es als vorteilhaft herausgestellt, das Modulationsmagnetfeld mit einer Amplitude zu versehen, die gerade dem Betrag des herkömmlichen Bias-Feldes entspricht.

Aus der Patentschrift US 8,222,898 B1 ist eine Vorrichtung zu entnehmen, die genau dasselbe Konzept der Frequenzumsetzung realisiert, indem eine kontrolliert bestromte Spule um den ME-Sensor herum angeordnet wird zur Erzeugung eines Modulationsmagnetfeldes mit einer Modulationsfrequenz in einem zur Messfrequenz komplementären Intervall.

Die Nachteile der bislang bekannten Frequenzumsetzung bei ME-Sensoren liegen in der Notwendigkeit zur Erzeugung eines möglichst homogenen, zeitlich veränderlichen Modulationsmagnetfeldes mit geeigneten apparativen Mitteln. Solche Mittel vorzusehen ist komplex und kostenträchtig. Es ist schwierig, das Modulationsmagnetfeld bei hohen Modulationsfrequenzen zu erzeugen. Überdies verbraucht die Magnetfelderzeugung nach dem Biot-Savart-Gesetz viel Energie. Nicht zuletzt sind die Modulationsmagnetfeldstärken auch groß gegenüber den Messfeldstärken und können erheblich benachbarte Sensoren stören, wenn etwa mehrere Messfeldkomponenten simultan gemessen werden sollen.

Die Erfindung stellt sich daher die Aufgabe, eine Magnetfeldmessung mit ME-Sensor und Frequenzumsetzung vorzuschlagen, die ohne Modulationsmagnetfeld auskommt und apparativ sehr einfach bleibt.

Verfahrensgemäß wird die Aufgabe durch den Anspruch 1 gelöst, nämlich durch ein Magnetfeldmessverfahren mit einem magnetoelektrischen Kompositelement als Oszillator, bei dem ein zeitabhängiges Messmagnetfeld auf die magnetostriktive Phase des Kompositelements wirkt, eine elektrische Messspannung über der piezoelektrischen Phase des Kompositelements abgegriffen wird und hieraus auf das Messmagnetfeld geschlossen wird, gekennzeichnet durch die Schritte (i) Vorsehen wenigstens einer dielektrischen Phase in stoffschlüssiger Verbindung mit der magnetostriktiven Phase des Kompositelements, wobei die dielektrische Phase bei Anlegen einer elektrischen Spannung eine Längenänderung zeigt, deren Betrag nicht-linear vom Betrag der Spannung abhängt, und (ii) Anlegen einer zeitlich periodischen elektrischen Modulationsspannung an die dielektrische Phase.

Die Aufgabe wird anordnungsgemäß in einer ersten Variante gelöst durch eine Magnetfeldmessvorrichtung gemäß Anspruch 2, aufweisend ein magnetoelektrisches Kompositelement mit einer piezoelektrischen Phase mit nicht-linearer Dehnungs-Spannungs-Kennlinie, wobei das Kompositelement als mechanisch schwingfähiger Oszillator ausgebildet ist, und eine Elektrodenanordnung auf der piezoelektrischen Phase sowie eine Einrichtung zum Abgreifen einer elektrischen Messspannung über der piezoelektrischen Phase bei Auslenkung des Oszillators, gekennzeichnet durch eine Einrichtung zum Beaufschlagen der piezoelektrischen Phase mit einer zeitlich periodischen elektrischen Modulationsspannung.

Die Aufgabe wird anordnungsgemäß in einer zweiten Variante gelöst durch eine Magnetfeldmessvorrichtung gemäß Anspruch 3, aufweisend ein magnetoelektrisches Kompositelement, wobei das Kompositelement als mechanisch schwingfähiger Oszillator ausgebildet ist, und eine erste Elektrodenanordnung auf der piezoelektrischen Phase des Kompositelements sowie eine Einrichtung zum Abgreifen einer elektrischen Messspannung über der piezoelektrischen Phase bei Auslenkung des Oszillators, gekennzeichnet durch eine dielektrische Phase mit nicht-linearer Dehnungs-Spannungs-Kennlinie in stoffschlüssiger Verbindung mit dem Kompositelement und eine zweite Elektrodenanordnung auf der dielektrischen Phase sowie eine Einrichtung zum Beaufschlagen der dielektrischen Phase mit einer zeitlich periodischen elektrischen Modulationsspannung.

Die weiteren Unteransprüche geben vorteilhafte Ausgestaltungen an.

In der zweiten Variante der vorgenannten Vorrichtung werden - anders als in der ersten Variante - keine weiteren Anforderungen an die piezoelektrische Phase des Kompositelements gestellt. Stattdessen wird eine zusätzliche dielektrische Phase stoffschlüssig am Kompositelement angeordnet, die eine nicht-lineare Längenänderung bei Anlegen einer elektrischen Spannung zeigt. Diese dielektrische Phase kann zugleich piezoelektrisch sein. Sie kann insbesondere aus einem Ferroelektrikum gebildet sein. Sie kann aber auch aus einem Relaxormaterial gebildet sein, das ausgeprägte Elektrostriktion zeigt, und womöglich nicht piezoelektrisch ist.

Als Ferroelektrika kommen für die Ausführung der Erfindung beispielsweise Blei-Zirkonat-Titanat (PZT), Bariumtitanat, Kalium-Natrium-Niobat (KNN) oder Natrium-Bismut-Titanat (NBT) in Betracht, um hier nur eine kleine Auswahl zu nennen.

Relaxormaterialien sind mit den Ferroelektrika verwandt. Sie zeigen ähnlich der Ferroelektrika bei höheren Temperaturen einen paraelektrischen Zustand. Wird die Temperatur verringert, zeigen sie keine Umwandlung in den ferroelektrischen Zustand verbunden mit einer Phasenumwandlung, sondern einen breiten, diffusen und stark frequenzabhängigen Übergang, der nicht mit einer strukturellen Umwandlung verbunden ist. Folglich sind sie nach wie vor kubisch und somit zentrosymmetrisch, also nicht piezoelektrisch. Allerdings zeigen sie eine sehr hohe Elektrostriktion. Beispiele für Relaxormaterialien sind Blei-Magnesium-Niobat (PMN) und Blei-Lanthan-Zirkonium-Titanat (PLZT).

Wie bereits in der EP 2 635 913 B1 besteht das Prinzip der Frequenzumsetzung darin, die Messspannung über einer piezoelektrischen Phase, die ihrerseits durch eine von einem Messmagnetfeld verursachte Dehnung einer magnetostriktiven Phase hervorgerufen wird, im Takte einer vorbestimmten periodischen Modulation zeitlich zu verändern. Die Modulation erfolgt dabei immer mit einem Signal großer Amplitude, i. F. Großsignal, das einen nichtlinearen Bereich einer materialspezifischen Dehnungs-Kennlinie durchläuft, bei gleichzeitiger Anwesenheit eines Messsignals kleinerer Amplitude, i. F. Kleinsignal, für dessen zusätzliche Aussteuerung sich die Dehnungs-Kennlinie wegen der Kleinheit der Amplitude näherungsweise linear verhält.

Bei der ME-Sensormessung von z.B. biomagnetischen Signalen ist das Kleinsignal wesentlich niederfrequenter als das Großsignal, d.h. über eine Periode des Großsignals ändert sich das Kleinsignal kaum. Das Kleinsignal "sieht" zeitlich variable Materialeigenschaften, die durch das Großsignal herbeigeführt werden. Insbesondere wird der piezoelektrische Koeffizient in der zum Abgriff der Messspannung vorgesehenen piezoelektrischen Phase im vorbestimmten Takt moduliert.

Im Falle der EP 2 635 913 B1 erfolgt die Modulation magnetisch, d.h. es wird ein magnetisches Modulationsmagnetfeld bereitgestellt, das über die magnetostriktive Phase - aufweisend eine vorbekannte, achsensymmetrische und schon deshalb nicht-lineare Magnetostriktionskennlinie - auch die piezoelektrische Phase dehnt und dadurch den piezoelektrischen Koeffizienten moduliert. Der zeitliche Verlauf der Dehnung durch das Kleinsignal wird durch das Großsignal kommutiert (Schwebung) und über die piezoelektrische Phase in eine Spannung umgesetzt, die Frequenzanteile mit der Eigenperiodendauer des oszillierenden ME-Sensors enthält, wenn die Modulationsfrequenz passend zur Messfeldfrequenz eingerichtet ist. Dadurch erfolgt eine Resonanzverstärkung des an sich niederfrequenten Kleinsignals, also des Messmagnetfeldes.

Bei der hier beschriebenen erfindungsgemäßen Magnetfeldmessung steuert demgegenüber eine eigens zu diesem Zweck angelegte, zeitlich periodische Modulationsspannung als Großsignal die zum Abgreifen der Messspannung vorgesehene piezoelektrische Phase aus. Die Umsetzung der Modulationsspannung in eine Dehnung bzw. Längenänderung der zum Signalabgriff vorgesehenen piezoelektrischen Phase des ME-Sensors erfolgt erfindungsgemäß durch die Längenänderung eines mit dem ME-Sensor stoffschlüssig verbundenen Dielektrikums in Abhängigkeit von der zeitlich periodischen Modulationsspannung. Das Dielektrikum bzw. die dielektrische Phase muss dabei eine nicht-lineare Dehnungs-Spannungs-Kennlinie aufweisen, die auch über ausgedehnte Bereiche der Nicht-Linearität von der Modulationsspannung durchlaufen werden muss; anderenfalls findet keine Frequenzumsetzung am ME-Sensor statt. Die dielektrische Phase mit nicht-linearer Dehnungs-Spannungs-Kennlinie kann bei geeigneter Materialauswahl mit der piezoelektrischen Phase für den Abgriff der Messspannung identisch sein. Über die magnetostriktive Phase wirkt eine zusätzliche Kleinsignal-Dehnung ein, die an der piezoelektrischen Phase gemäß dem differentiellen piezoelektrischen Koeffizienten in Messspannung gewandelt wird. Da der differentielle piezoelektrische Koeffizient bei positiver Modulationsspannung positiv (und umgekehrt) ist, wird die entstehende Messspannung ebenfalls im Takt der Modulationsspannung kommutiert, was letztlich ähnlich wirkt, wie schon bei der magnetischen Modulation.

Die elektrisch getriebene Modulation des ME-Sensors ist wesentlich schneller und energiesparender als die magnetische Modulation.

In der oben genannten ersten Variante der erfindungsgemäßen Magnetfeldmessvorrichtung wird die Modulationsspannung an die piezoelektrische Phase eines an sich bekannten ME-Sensors angelegt, wobei die piezoelektrische Phase eine nicht-lineare Dehnungs-Spannungs-Kennlinie aufweisen muss. Die piezoelektrische Phase kann beispielsweise aus PZT gebildet sein. Es ist aber nach experimentellen Befunden unzureichend, wenn die piezoelektrische Phase etwa aus Aluminiumnitrid (AIN) gebildet ist, denn dieses Material zeigt über große Spannungsbereiche ein ausgeprägt lineares Dehnungsverhalten. Die angestrebte Frequenzumsetzung ist dann nicht zu beobachten. Eine piezoelektrische Phase mit nicht-linearer Dehnungs-Spannungs-Kennlinie erfüllt simultan zwei Aufgaben: (i) sie bewirkt die nicht-lineare Dehnung des magnetoelektrischen Kompositelements als Antwort auf die Modulationsspannung und (ii) sie dient dem Abgreifen der piezoelektrischen Messspannung, sobald ein zeitabhängiges Magnetfeld auf die magnetostriktive Phase wirkt.

In der zweiten Variante der erfindungsgemäßen Magnetfeldmessvorrichtung wird eine zusätzliche dielektrische Phase mit nicht-linearer Dehnungs-Spannungs-Kennlinie stoffschlüssig am Kompositelement angeordnet und mit der Modulationsspannung beaufschlagt. Diese zusätzliche Materialphase hat nur die Funktion eines Antriebs, der die Modulationsspannung nicht-linear in eine Dehnung überführt und diese an die magnetostriktive Phase über die stoffschlüssige Verbindung der Phasen miteinander weitergibt. Die dielektrische Phase wird bevorzugt aus einem Ferroelektrikum, z.B. aus PZT, oder aus einem Relaxormaterial gebildet. Insbesondere ist jedes dielektrische Material geeignet, das ausgeprägte Elektrostriktion zeigt, da analog zur Magnetostriktion auch die Elektrostriktionskennlinie achsensymmetrisch und damit deutlich nicht-linear verläuft. Beispielsweise zeigt Bleimagnesiumniobat (PMN) solche Elektrostriktion. Die piezoelektrische Phase in der zweiten Variante dient demgegenüber allein zum Abgreifen der Messspannung in Anwesenheit eines zeitabhängigen Magnetfeldes. Sie kann beispielsweise aus PZT, PVDF oder auch aus Aluminiumnitrid gebildet sein.

Die Modulationsspannung soll zeitlich periodisch sein und dabei bevorzugt eine Periodendauer aufweisen, die sich um einen vorbestimmten Differenzbetrag größer als null von der Eigenperiodendauer des mechanischen Oszillators - d.h. des ME-Sensors - unterscheidet. Sie kann dabei einen harmonischen Zeitverlauf aufweisen, sie kann aber auch eine periodische Dreieck- oder Rechteckspannung oder ähnliches sein. Die Modulationsspannung soll vorzugsweise den ME-Sensor zu einer erzwungenen Schwingung abseits seiner Eigenschwingung veranlassen.

In einer bevorzugten Ausgestaltung ist die Modulationsspannung eine Rechteckspannung, die den differentiellen piezoelektrischen Koeffizienten in der zum Messspannungsabgriff vorgesehenen piezoelektrischen Phase zwischen positiven und negativen Werten hin- und herschaltet. Besonders bevorzugt werden dabei positive und negative Maximalwerte realisiert.

Die Erfindung wird im Folgenden noch näher erläutert anhand eines Ausführungsbeispiels und der Erklärung von Messdaten. Dabei zeigen die Figuren:
- Fig. 1: die Schnitt-Skizze eines streifenförmigen ME-Sensors gemäß der beschriebenen zweiten Variante der Magnetfeldmessvorrichtung;
- Fig. 2: die Messspannungen eines ME-Sensors des Aufbaus nach Fig. 1, der in Dünnschichttechnik realisiert worden ist.

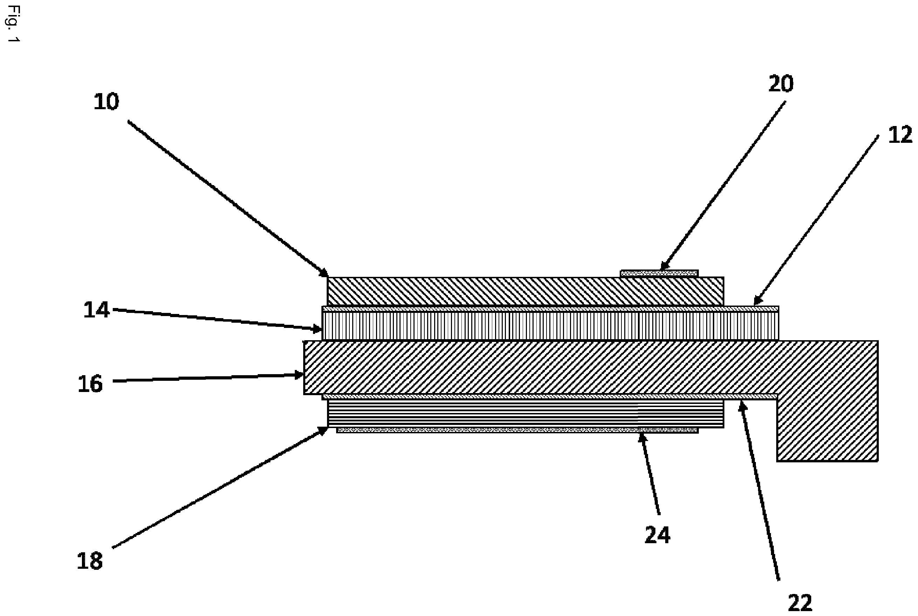

In Fig. 1 ist eine Schnittskizze durch einen ME-Sensor in Streifenform dargestellt, der als Ausführungsbeispiel der zweiten Variante der Magnetfeldmessvorrichtung in Dünnschichttechnik realisierbar ist. Die Skizze ist nicht maßstabsgerecht.

Auf einem Siliziumsubstratfilm (16) mit 300 µm Filmdicke wird auf der Oberseite ein magnetostriktives Schichtsystem (14) nach der Lehre der EP 2 538 235 B1 mit FeCoSiB als magnetostriktivem Material gebracht. Dieses Schichtsystem (14) enthält antiferromagnetische Lagen und bildet durch Exchange Bias lagengebundene Magnetfelder aus, die das Schichtsystem (14) insgesamt in einen Arbeitspunkt mit günstigem piezomagnetischem Koeffizienten befördern, ohne dass außerhalb des Schichtsystems (14) nennenswerte magnetische Streufelder auftreten. Die mittels Exchange Bias eingerichtete Bias-Gleichfeldstärke liegt etwa bei 5 Oe.

Auf das Schichtsystem (14) und auf die Unterseite des Substratfilms (16) werden jeweils 100 Nanometer dicke metallische Schichten aus Tantal/Platin aufgebracht, die auch als Unterelektroden (12, 22) dienen.

Die piezoelektrische Phase (10) - hier: Schicht der Dicke 2 µm - ist im Beispiel aus Aluminiumnitrid gebildet auf der oberen Unterelektrode (12). Die dielektrische Phase (18) - hier: Schicht der Dicke 2 µm - mit nicht-linearer Dehnungs-Spannungs-Kennlinie ist aus PZT gebildet und auf die untere Unterelektrode (22) aufgebracht.

Zwischen der - in der Regel - leitfähigen, magnetostriktiven Phase (14) und der piezoelektrischen Phase (10) ist die Unterelektrode (12) gewöhnlich nicht zwingend erforderlich. Sie dient hier in erster Linie der Texturlöschung zur Erzeugung einer besseren Piezoschicht (10) und wird nebenbei als Unterelektrode (12) benutzt.

Demgegenüber ist es unerlässlich, eine erste Elektrodenanordnung (20) auf der piezoelektrischen Schicht (10) zum Abgreifen der Messspannung vorzusehen. In der zweiten Variante der erfindungsgemäßen Magnetfeldmessvorrichtung wird überdies eine zweite Elektrodenanordnung (24) auf der dielektrischen Schicht (18) mit nicht-linearer Dehnungs-Spannungs-Kennlinie aufgebracht. Diese dient dem Anlegen der erfindungsgemäßen Modulationsspannung, im vorliegenden Beispiel über die dielektrische Schicht (18) mittels der Elektroden (22, 24). Die jeweils außen angeordneten Elektroden (20, 24) sind aus Chrom/Gold gebildet und ca. 100 Nanometer dick.

Gegenüber der zweiten Variante der Magnetfeldmessvorrichtung entfallen bei der ersten Variante alle Materialschichten (18, 22, 24) auf der Unterseite des Substratfilms (16) unter der Voraussetzung, dass die piezoelektrische Phase (10) aus einem Material mit nicht-linearer Dehnungs-Spannungs-Kennlinie gebildet wird, beispielsweise aus PZT, aber eben gerade nicht aus Aluminiumnitrid.

Es liegt im Rahmen der Erfindung, die Auswahl, Dimensionierung und Reihenfolge der Materialschichten insbesondere auch nach der Lehre der EP 2 717 343 B1 vorzunehmen, so dass die Elektroden (22, 24) auch einzeln oder beide als Interdigitalelektroden ausgestaltet sein können, und elektrische Spannungen entlang der Schichten - und nicht über die Schichtdicken - angelegt oder abgegriffen werden können.

Auf der rechten Seite der Fig. 1 wird durch einen Block angedeutet, dass der Substratfilm (16) beispielsweise aus einem Siliziumwafer herausgearbeitet sein kann. Der Block symbolisiert ganz allgemein eine einseitige Fixierung des ME-Sensors am rechten Rand, so dass er nach Art eines freitragenden Balkens oszillieren kann. Im Ausführungsbeispiel wird die mechanische Eigenfrequenz des ME-Sensors zu f_{R} = 688 Hz bestimmt. Der Biegebalken ist etwa 20 mm lang - frei stehend - und ca. 2 mm breit.

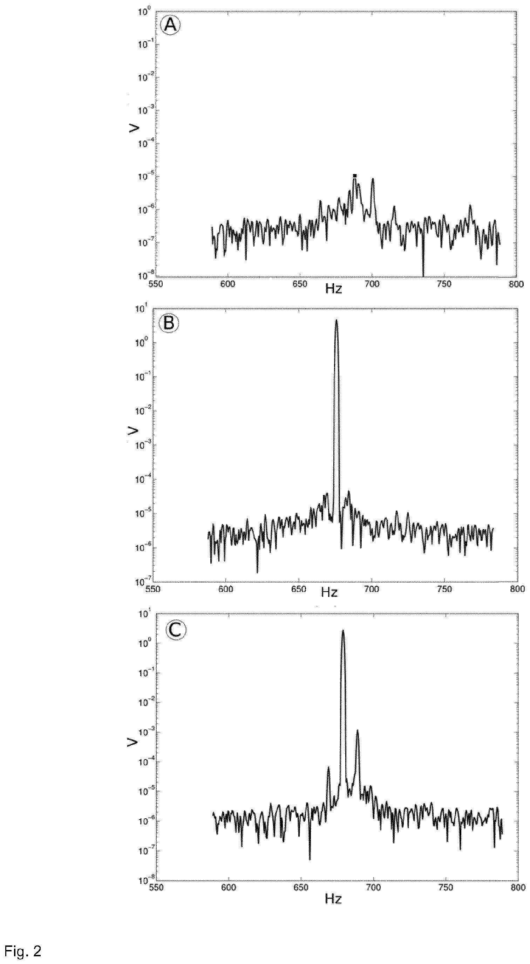

In Fig. 2 ist die Messspannung abgegriffen zwischen den Elektroden (12) und (20) über der Piezoschicht (10) als Funktion der Frequenz dargestellt. Fig. 2 A zeigt dabei das Signal in Abwesenheit elektrischer oder magnetischer Wechselfelder; es erfolgt nur eine akustische Einkopplung (Störung durch Luftschall). Es ist zu beachten, dass die Messspannung auf logarithmischer Skala angegeben wird.

Fig. 2 B zeigt die Messspannung, wenn eine periodische Modulationsspannung U_{A}(t) = U₀ cos(2π f_{mod} t) mit U₀ als Amplitude und f_{mod} als Modulationsfrequenz an die Elektroden (22) und (24) angelegt wird. Im Beispiel der Fig. 2 B ist U₀ = 40 V und f_{mod} = 678 Hz. Nur eine Frequenzkomponente der Messspannung - eben die für f_{mod} - ist dominant, d.h. der ME-Sensor vollführt eine erzwungene Schwingung neben seiner Eigenfrequenz.

Die Messspannung in Fig. 2 C weist einen Hauptanteil mit der Frequenz f_{mod} auf und zwei Seitenbandanteile bei den Frequenzen f_{mod} - fₘₑₛₛ und f_{mod} + fₘₑₛₛ, wenn zusätzlich zur Modulationsspannung - in diesem Fall eine Rechteckspannung mit Periodendauer 1/f_{mod} - über der dielektrischen Phase (18) auch ein Messmagnetfeld mit Frequenz fₘₑₛₛ auf die magnetostriktive Phase (14) wirkt. Im Beispiel der Fig. 2 C hat die Messfeldstärke die Amplitude Hₘₑₛₛ = 10 Oe, die Messfeldfrequenz ist fₘₑₛₛ = 10 Hz und die Amplitude der Modulationsspannung beträgt U₀ = 5 V. Da das rechte Seitenband (688 Hz) genau die Resonanz des ME-Sensors erregt, wird die Messspannung wie gewollt überhöht - hier um mehr als eine Größenordnung gegenüber dem linken Seitenband.

Insbesondere kann bei der vorliegenden Erfindung f_{mod} über ein vorbestimmtes Frequenzintervall variiert werden, um ein Frequenzband von Messmagnetfeldern zu durchlaufen. Für beliebige zeitlich periodische Modulationsspannungen, bevorzugt Rechteckspannungen, ist die Einrichtung zum Beaufschlagen mit Modulationsspannung vorteilhaft dazu ausgebildet, allgemein die Periodendauer der Modulationsspannung zwischen vorbestimmten Intervallgrenzen automatisch zu variieren.

Die Fig. 2 zeigt die Frequenzanteile der Messspannung als unmittelbare Ausgaben eines Spektralanalysators, dem die Spannungswerte fortlaufend zugeführt worden sind. Eine nachgeschaltete Auswerteeinrichtung kann vorteilhaft dazu ausgebildet sein, die Messspannung als Funktion der Periodendauer der Modulationsspannung zu erfassen und aufzuzeichnen und/oder auszugeben. Bevorzugt ermittelt die Auswerteeinrichtung dabei lokale Maxima der Messspannung und schließt aus Betrag und Position wenigstens eines ermittelten Maximums auf Amplitude und Frequenz wenigstens einer zu messenden Magnetfeldkomponente. Im einfachsten Fall erfolgt die Übersetzung von Messspannung in Magnetfeldstärke anhand einer in einem einmaligen Vorversuch erstellten Kalibriertabelle.

Die automatische Suche und Übersetzung von lokalen Spannungsmaxima in Magnetfeldstärken unterstützt auch das schnelle Durchsuchen eines vorbestimmten Periodendauerintervalls bzw. Frequenzbandes nach etwaig vorhandenen Frequenzanteilen des Messmagnetfeldes, wenn dieses mehrere - a priori womöglich unbekannte - Frequenzen aufweist. Dabei kann es vorteilhaft sein, eine Rückkopplung der Auswerteeinheit auf die Einrichtung zur Beaufschlagung mit Modulationsspannung, die ihrerseits das Variieren der Modulationsfrequenz steuert, vorzusehen. Modulationsfrequenzbereiche, die zu ausgeprägten lokalen Spannungsmaxima führen, können so mit angepasster - bevorzugt reduzierter - Geschwindigkeit durchsucht werden, etwa um genauere Peak-Werte zu bestimmen.

Die EP 2 635 913 B1 sagt aus, dass die Frequenzumsetzung ohne ein konstantes Bias-Magnetfeld entlang der magnetostriktiven Phase gelingt. Bevorzugt wird dabei die Amplitude des Modulationsmagnetfeldes etwa bei der Feldstärke des herkömmlichen Bias-Konstantfeldes eingerichtet, das man ansonsten bräuchte, um den Bereich des maximalen piezomagnetischen Koeffizienten in der magnetostriktiven Phase als Arbeitspunkt des ME-Sensors einzustellen.

Grundsätzlich ist bei der vorliegenden Erfindung ein Bias-Konstantfeld ebenfalls völlig verzichtbar, aber man wird bei der elektrischen Modulation die magnetostriktive Phase (14) in der Regel nicht soweit dehnen, dass sie in den Zustand mit maximalem piezomagnetischem Koeffizienten gerät. Es kann daher hier vorteilhaft sein, ein Bias-Feld zur Optimierung des Arbeitspunktes des ME-Sensors vorzusehen. Besonders vorteilhaft ist es dabei, die magnetostriktive Phase (14) als mehrlagiges Schichtsystem mit abwechselnden ferromagnetischen und antiferromagnetischen Lagen auszugestalten, die nach der Lehre der EP 2 538 235 B1 eine Vormagnetisierung des Schichtsystems durch Exchange Bias ohne nennenswerte Streufelder erlauben (vgl. Ausführungsbeispiel). Auf diese Weise kann eine hohe Empfindlichkeit für schwache, niederfrequente Magnetfelder auch dann erreicht werden, wenn eine Mehrzahl von ME-Sensoren auf engem Raum benachbart angeordnet werden.

## Patentansprüche

1. Magnetfeldmessverfahren mit einem magnetoelektrischen Kompositelement als Oszillator, wobei das Kompositelement aus einer magnetostriktiven Phase (14) sowie einer piezoelektrischen Phase (10) in stoffschlüssiger Verbindung gebildet ist, wobei bei dem Magnetfeldmessverfahren ein zeitabhängiges Messmagnetfeld auf die magnetostriktive Phase (14) des Kompositelements wirkt, eine elektrische Messspannung über der piezoelektrischen Phase (10) des Kompositelements abgegriffen wird und hieraus auf das Messmagnetfeld geschlossen wird, **gekennzeichnet durch die Schritte**
(i) Vorsehen wenigstens einer dielektrischen Phase (18) in stoffschlüssiger Verbindung mit der magnetostriktiven Phase (14) des Kompositelements, wobei die dielektrische Phase (18) bei Anlegen einer elektrischen Spannung eine Längenänderung zeigt, deren Betrag nicht-linear vom Betrag der Spannung abhängt, und
(ii) Anlegen einer zeitlich periodischen elektrischen Modulationsspannung an die dielektrische Phase (18).

2. Magnetfeldmessvorrichtung zur Umsetzung des Magnetfeldmessverfahrens nach Anspruch 1 aufweisend ein magnetoelektrisches Kompositelement, das aus einer magnetostriktiven Phase (14) sowie einer piezoelektrischen Phase (10) in stoffschlüssiger Verbindung gebildet ist, wobei die piezoelektrische Phase (10) eine nicht-lineare Dehnungs-Spannungs-Kennlinie aufweist, wobei das Kompositelement als mechanisch schwingfähiger Oszillator ausgebildet ist, und eine Elektrodenanordnung (12, 20) auf der piezoelektrischen Phase (10) sowie eine Einrichtung ausgebildet zum Abgreifen einer elektrischen Messspannung über der piezoelektrischen Phase (10) bei Auslenkung des Oszillators, **gekennzeichnet durch**
eine Einrichtung ausgebildet zum Beaufschlagen der piezoelektrischen Phase (10) mit einer zeitlich periodischen elektrischen Modulationsspannung.

3. Magnetfeldmessvorrichtung zur Umsetzung des Magnetfeldmessverfahrens nach Anspruch 1 aufweisend ein magnetoelektrisches Kompositelement, das aus einer magnetostriktiven Phase (14) sowie einer piezoelektrischen Phase (10) in stoffschlüssiger Verbindung gebildet ist, wobei das Kompositelement als mechanisch schwingfähiger Oszillator ausgebildet ist, und eine erste Elektrodenanordnung (12, 20) auf der piezoelektrischen Phase (10) des Kompositelements sowie eine Einrichtung ausgebildet zum Abgreifen einer elektrischen Messspannung über der piezoelektrischen Phase (10) bei Auslenkung des Oszillators,
**gekennzeichnet durch**
eine dielektrische Phase (18) mit nicht-linearer Dehnungs-Spannungs-Kennlinie in stoffschlüssiger Verbindung mit dem Kompositelement und eine zweite Elektrodenanordnung (22, 24) auf der dielektrischen Phase (18) sowie eine Einrichtung ausgebildet zum Beaufschlagen der dielektrischen Phase (18) mit einer zeitlich periodischen elektrischen Modulationsspannung.

4. Magnetfeldmessvorrichtung nach Anspruch 2,
**dadurch gekennzeichnet, dass**
die piezoelektrische Phase (10) aus einem Ferroelektrikum gebildet ist.

5. Magnetfeldmessvorrichtung nach Anspruch 3,
**dadurch gekennzeichnet, dass**
die dielektrische Phase (18) aus einem Ferroelektrikum oder einem Relaxormaterial gebildet ist.

6. Magnetfeldmessvorrichtung nach einem der Ansprüche 4 oder 5,
**dadurch gekennzeichnet, dass**
das Ferroelektrikum ein Material aus der Gruppe Blei-Zirkonat-Titanat (PZT), Bariumtitanat, Kalium-Natrium-Niobat (KNN) oder Natrium-Bismut-Titanat (NBT) ist.

7. Magnetfeldmessvorrichtung nach Anspruch 5,
**dadurch gekennzeichnet, dass**
das Relaxormaterial ein Material aus der Gruppe Blei-Magnesium-Niobat (PMN) oder Blei-Lanthan-Zirkonium-Titanat (PLZT) ist.

8. Magnetfeldmessvorrichtung nach einem der vorangehende Ansprüche 2 bis 7,
**dadurch gekennzeichnet, dass**
die Einrichtung ausgebildet zum Beaufschlagen mit Modulationsspannung zur Vorgabe einer Periodendauer der Modulationsspannung ausgebildet ist, die sich um einen vorbestimmten Differenzbetrag größer als null von der Eigenperiodendauer des mechanischen Oszillators unterscheidet.

9. Magnetfeldmessvorrichtung nach Anspruch 8,
**dadurch gekennzeichnet, dass**
die Einrichtung ausgebildet zum Beaufschlagen mit Modulationsspannung dazu ausgebildet ist, eine
Rechteckspannung auszugeben, die eine periodische nicht-lineare Dehnung der piezoelektrischen Phase (10) bewirkt, bei der der differentielle piezoelektrische Koeffizient in der piezoelektrischen Phase (10) zwischen positiven und negativen Werten hin- und her geschaltet wird.

10. Magnetfeldmessvorrichtung nach einem der Ansprüche 8 oder 9,
**dadurch gekennzeichnet, dass**
die Einrichtung ausgebildet zum Beaufschlagen mit Modulationsspannung dazu ausgebildet ist, die Periodendauer der Modulationsspannung zwischen vorbestimmten Intervallgrenzen automatisch zu variieren.

11. Magnetfeldmessvorrichtung nach einem der vorangehenden Ansprüche 2 bis 10,
**dadurch gekennzeichnet, dass**
eine Auswerteeinrichtung dazu ausgebildet ist, die Messspannung als Funktion der Periodendauer der Modulationsspannung zu erfassen und aufzuzeichnen und/oder auszugeben.

12. Magnetfeldmessvorrichtung nach Anspruch 11,
**dadurch gekennzeichnet, dass**
die Auswerteeinrichtung dazu ausgebildet ist, lokale Maxima der Messspannung zu ermitteln und aus Betrag und Position wenigstens eines ermittelten Maximums auf Amplitude und Frequenz wenigstens einer zu messenden Magnetfeldkomponente zu schließen.

13. Magnetfeldmessvorrichtung nach einem der vorangehenden Ansprüche 2 bis 12,
**dadurch gekennzeichnet, dass**
die magnetostriktive Phase (14) als mehrlagiges Schichtsystem mit abwechselnden ferromagnetischen und antiferromagnetischen Lagen ausgebildet ist.

## Claims

1. Magnetic field measuring method using a magnetoelectric composite element as oscillator, wherein the composite element is formed of a magnetostrictive phase (14) and a piezoelectric phase (10) which are connected by a material bond, wherein during the magnetic field measuring method a time-dependent measurement magnetic field acts on the magnetostrictive phase (14) of the composite element, an electrical measurement voltage is tapped off across the piezoelectric phase (10) of the composite element, and the measurement magnetic field is inferred therefrom,
**characterized by** the steps:
(i) providing at least one dielectric phase (18) which is connected to the magnetostrictive phase (14) of the composite element by a material bond, wherein, when an electrical voltage is applied, the dielectric phase (18) exhibits a change in length, the magnitude of which depends in a non-linear manner on the magnitude of the voltage, and
(ii) applying a temporally periodic electrical modulation voltage to the dielectric phase (18).

2. Magnetic field measuring device for carrying out the magnetic field measuring method according to claim 1, comprising a magnetoelectric composite element which is formed of a magnetostrictive phase (14) and a piezoelectric phase (10) which are connected by a material bond, wherein the piezoelectric phase (10) has a non-linear stress-strain characteristic, wherein the composite element is designed as a mechanically vibratable oscillator, and an electrode arrangement (12, 20) on the piezoelectric phase (10), and a means designed to tap off an electrical measurement voltage across the piezoelectric phase (10) upon deflection of the oscillator,
**characterized by**
a means designed to apply a temporally periodic electrical modulation voltage to the piezoelectric phase (10).

3. Magnetic field measuring device for carrying out the magnetic field measuring method according to claim 1, comprising a magnetoelectric composite element which is formed of a magnetostrictive phase (14) and a piezoelectric phase (10) which are connected by a material bond, wherein the composite element is designed as a mechanically vibratable oscillator, and a first electrode arrangement (12, 20) on the piezoelectric phase (10) of the composite element, and a means designed to tap off an electrical measurement voltage across the piezoelectric phase (10) upon deflection of the oscillator,
**characterized by**
a dielectric phase (18) which has a non-linear stress-strain characteristic and which is connected to the composite element by a material bond, and a second electrode arrangement (22, 24) on the dielectric phase (18), and a means designed to apply a temporally periodic electrical modulation voltage to the dielectric phase (18).

4. Magnetic field measuring device according to claim 2, **characterized in that**
the piezoelectric phase (10) is formed of a ferroelectric.

5. Magnetic field measuring device according to claim 3, **characterized in that**
the dielectric phase (18) is formed of a ferroelectric or of a relaxor material.

6. Magnetic field measuring device according to any one of claims 4 or 5,
**characterized in that**
the ferroelectric is a material from the group consisting of lead zirconate titanate (PZT), barium titanate, potassium sodium niobate (KNN), or sodium bismuth titanate (NBT).

7. Magnetic field measuring device according to claim 5, **characterized in that**
the relaxor material is a material from the group consisting of lead magnesium niobate (PMN) or lead lanthanum zirconium titanate (PLZT).

8. Magnetic field measuring device according to any one of the preceding claims 2 to 7,
**characterized in that**
the means designed to apply a modulation voltage is designed to specify a period of the modulation voltage which differs from the intrinsic period of the mechanical oscillator by a predetermined difference greater than zero.

9. Magnetic field measuring device according to claim 8, **characterized in that**
the means designed to apply a modulation voltage is designed to output a square-wave voltage which brings about a periodic non-linear expansion of the piezoelectric phase (10), during which the differential piezoelectric coefficient in the piezoelectric phase (10) is switched back and forth between positive and negative values.

10. Magnetic field measuring device according to any one of claims 8 or 9,
**characterized in that**
the means designed to apply a modulation voltage is designed to automatically vary the period of the modulation voltage between predetermined interval limits.

11. Magnetic field measuring device according to any one of the preceding claims 2 to 10,
**characterized in that**
an evaluation device is designed to detect and record and/or output the measurement voltage as a function of the period of the modulation voltage.

12. Magnetic field measuring device according to claim 11, **characterized in that**
the evaluation device is designed to determine local maxima of the measurement voltage and to infer from the magnitude and position of at least one determined maximum the amplitude and frequency of at least one magnetic field component to be measured.

13. Magnetic field measuring device according to any one of the preceding claims 2 to 12,
**characterized in that**
the magnetostrictive phase (14) is designed as a multilayer system having alternating ferromagnetic and antiferromagnetic layers.

## Revendications

1. Procédé de mesure d'un champ magnétique avec comme oscillateur un élément composite magnétoélectrique, l'élément composite étant formé d'une phase magnétostrictive (14) et d'une phase piézoélectrique (10) reliées ensemble par une liaison de matière, dans lequel procédé de mesure d'un champ magnétique, un champ magnétique de mesure dépendant du temps agit sur la phase magnétostrictive (14) de l'élément composite, une tension de mesure électrique est prélevée par le biais de la phase piézoélectrique (10) de l'élément composite et le champ magnétique de mesure est déduit de celle-ci, **caractérisé par** les étapes consistant à
(i) prévoir au moins une phase diélectrique (18) en liaison de matière avec la phase magnétostrictive (14) de l'élément composite, la phase diélectrique (18) présentant, lors de l'application d'une tension électrique, une variation de longueur dont l'amplitude dépend de manière non linéaire de l'amplitude de la tension, et
(ii) appliquer à la phase diélectrique (18) une tension de modulation électrique périodique dans le temps.

2. Dispositif de mesure d'un champ magnétique pour la mise en œuvre du procédé de mesure d'un champ magnétique selon la revendication 1, muni d'un élément composite magnétoélectrique formé d'une phase magnétostrictive (14) et d'une phase piézoélectrique (10) reliées ensemble par une liaison de matière, la phase piézoélectrique (10) présentant une courbe caractéristique allongement-tension non linéaire, l'élément composite étant conçu comme un oscillateur pouvant osciller mécaniquement, et d'un agencement d'électrodes (12, 20) sur la phase piézoélectrique (10) ainsi que d'un dispositif configuré pour prélever une tension de mesure électrique par le biais de la phase piézoélectrique (10) lors de la déviation de l'oscillateur, **caractérisé par** un dispositif conçu pour appliquer à la phase piézoélectrique (10) une tension de modulation électrique périodique dans le temps.

3. Dispositif de mesure d'un champ magnétique pour la mise en œuvre du procédé de mesure d'un champ magnétique selon la revendication 1, muni d'un élément composite magnétoélectrique formé d'une phase magnétostrictive (14) et d'une phase piézoélectrique (10) reliées ensemble par une liaison de matière, l'élément composite étant conçu comme un oscillateur pouvant osciller mécaniquement, et d'un premier agencement d'électrodes (12, 20) sur la phase piézoélectrique (10) de l'élément composite ainsi que d'un dispositif conçu pour prélever une tension de mesure électrique par le biais de la phase piézoélectrique (10) lors de la déviation de l'oscillateur, **caractérisé par** une phase diélectrique (18) avec une courbe caractéristique allongement-tension non linéaire en liaison de matière avec l'élément composite, et un deuxième agencement d'électrodes (22, 24) sur la phase diélectrique (18) ainsi qu'un dispositif conçu pour appliquer à la phase diélectrique (18) une tension de modulation électrique périodique dans le temps.

4. Dispositif de mesure d'un champ magnétique selon la revendication 2, **caractérisé en ce que** la phase piézoélectrique (10) est formée d'un matériau ferroélectrique.

5. Dispositif de mesure d'un champ magnétique selon la revendication 3, **caractérisé en ce que** la phase diélectrique (18) est formée d'un matériau ferroélectrique ou d'un matériau relaxeur.

6. Dispositif de mesure d'un champ magnétique selon l'une des revendications 4 ou 5, **caractérisé en ce que** le matériau ferroélectrique est un matériau du groupe constitué par le titano-zirconate de plomb (PZT), le titanate de baryum, le niobate de sodium et de potassium (KNN) ou le titanate de bismuth et de sodium (NBT).

7. Dispositif de mesure d'un champ magnétique selon la revendication 5, **caractérisé en ce que** le matériau relaxeur est un matériau du groupe constitué par le niobate de magnésium et de plomb (PMN) ou le titanate de lanthane et de zirconium (PLZT).

8. Dispositif de mesure d'un champ magnétique selon l'une des revendications précédentes 2 à 7, **caractérisé en ce que** le dispositif est conçu pour appliquer une tension de modulation afin de spécifier une durée de période de la tension de modulation qui diffère de la durée de période intrinsèque de l'oscillateur mécanique d'une valeur de différence prédéterminée supérieure à zéro.

9. Dispositif de mesure d'un champ magnétique selon la revendication 8, **caractérisé en ce que** le dispositif conçu pour appliquer une tension de modulation est conçu pour produire une tension rectangulaire qui provoque un allongement périodique non linéaire de la phase piézoélectrique (10), par lequel le coefficient piézoélectrique différentiel dans la phase piézoélectrique (10) est commuté successivement entre des valeurs positives et négatives.

10. Dispositif de mesure d'un champ magnétique selon l'une des revendications 8 ou 9, **caractérisé en ce que** le dispositif conçu pour appliquer une tension de modulation est conçu pour faire varier automatiquement la durée de la période de la tension de modulation entre des limites d'intervalle prédéterminées.

11. Dispositif de mesure d'un champ magnétique selon l'une des revendications précédentes 2 à 10, **caractérisé en ce qu'**un dispositif d'évaluation est conçu pour saisir et enregistrer et/ou délivrer la tension de mesure sous la forme d'une fonction de la durée de la période de la tension de modulation.

12. Dispositif de mesure d'un champ magnétique selon la revendication 11, **caractérisé en ce que** le dispositif d'évaluation est conçu pour déterminer des maximas locaux de la tension de mesure et pour déduire, à partir de la valeur et de la position d'au moins un maximum déterminé, l'amplitude et la fréquence d'au moins une composante de champ magnétique à mesurer.

13. Dispositif de mesure d'un champ magnétique selon l'une des revendications 2 à 12 précédentes, **caractérisé en ce que** la phase magnétostrictive (14) est conçue sous la forme d'un système de couches multicouches avec des couches ferromagnétiques et antiferromagnétiques alternées.
